# EUROPÄISCHE PATENTSCHRIFT

(11) **EP 1 469 504 B1**
(45) Veröffentlichungstag und Bekanntmachung des Hinweises auf die Patenterteilung: **10.10.2012**
(21) Anmeldenummer: 04002809.4
(22) Anmeldetag: 09.02.2004
(51) Int. Cl.: H01J 37/34

(54) **Magnetron mit zweistufiger Dichtung**
Magnetron comprising a two-fold seal
Magnétron à double joint d'étanchéité

(30) Priorität: 21.03.2003 DE 10312632
(43) Veröffentlichungstag der Anmeldung: 20.10.2004
(73) Patentinhaber: INTERPANE Entwicklungs- und Beratungsgesellschaft mbH, 37697 Lauenförde (DE)
(72) Erfinder: Landgraf, Ralf, 94579 Zentning (DE); Herwig, Wilhelm, 37688 Beverungen (DE)
(74) Vertreter: Körfer, Thomas

(56) Entgegenhaltungen:
- US-A- 5 096 562

## Beschreibung

Die Erfindung bezieht sich auf ein Magnetron nach dem Oberbegriff des Anspruchs 1.

Beispielsweise ist aus der WO 91/07521 ein zylindrisches Magnetron bekannt, welches in einer Vakuumkammer-Umfassung aufgebaut ist. Es weist mindestens eine längliche, zylindrisch geformte Targetkonstruktion auf, die innerhalb der Vakuumkammer in einer um ihre Längsachse drehbaren Weise gelagert ist, sowie mit der Targetkonstruktion antriebsmäßig verbundene Mittel zum Drehen der Targetkonstruktion um deren Längsachse. Eine Magnetkonstruktion erstreckt sich innerhalb der Targetkonstruktion im wesentlichen über deren gesamte Länge und ist gegen ein Mitdrehen mit der Targetkonstruktion festgelegt. Eine Mehrzahl von Rollen ist an der Magnetkonstruktion gehaltert und stützt sich an der Innenseite der Targetkonstruktion ab, um so eine Trennung zwischen der Magnetkonstruktion und der Innenfläche der Targetkonstruktion aufrechtzuerhalten.

Nachteilig an dem aus der WO 91/07521 bekannten Magnetron ist insbesondere, daß der Kühlmittelkreislauf durch eine komplizierte Dichtung gegen die Vakuumkammer abgedichtet werden muß. Die Abdichtung erfolgt dabei mittels eines Dichtungsgehäuses, welches mit einem Satz O-Ringe versehen ist. Diese sind in Nuten angeordnet, die in dem Dichtungsgehäuse ausgebildet sind. Die Konstruktion ist aufwendig und kostenintensiv und bedingt durch die Vielzahl von Bauteilen auch störanfällig.

Der Erfindung liegt daher die Aufgabe zu Grunde, bei einem Magnetron nach dem Oberbegriff des Anspruchs 1 eine zuverlässige und dabei einfache und kostengünstige Abdichtung des Kühlmittelkreislaufs gegenüber der Vakuumkammer zu erzielen.

Die Aufgabe wird durch die Merkmale des Anspruchs 1 gelöst.

Vorteilhafterweise sind bei dem erfindungsgemäß ausgestalteten Magnetron dabei zumindest einer ersten, zweiten und dritten, voneinander getrennte Dichtungen vorgesehen, die jeweils nur einen Teil der anliegenden Drücke aufnehmen müssen und an unterschiedlichen Stellen der Vakuumkammer angeordnet sind. Es werden dabei Medien mit geringeren Druckunterschieden gegeneinander abgedichtet, so daß keine der Dichtungen den vollen Druckunterschied zwischen dem mit Druck beaufschlagten Kühlmedium und dem Vakuum der Vakuumkammer aufnehmen muß. So kann sichergestellt werden, daß eine zuverlässige Dichtwirkung bei einfacher und kostengünstiger Herstellung der einzelnen Dichtungen erzielt werden kann.

Das erfindungsgemäße Magnetron weist dabei vorteilhafterweise an jedem Ende eine Dichtung auf, welche die Vakuumkammer gegen die Umgebung abdichtet, und eine Dichtung, welche den Kühlmittelkreislauf gegen die Umgebung abdichtet.

Vorteilhafte Weiterbildungen der Erfindung sind in den Unteransprüchen beschrieben.

Weiterhin ist von Vorteil, daß die Dichtungen in einfacher Weise in Nuten liegen, in welche sie durch den äußeren Druck eingepreßt werden, so daß eine zuverlässige Dichtwirkung erzielt wird.

Vorteilhafterweise sind die Dichtungen in Flanschen angeordnet, welche einfach herstellbar sind und zudem als Lagerteile für die beweglichen Teile des Magnetrons dienen können.

Die Vakuumkammer ist trogförmig ausgebildet und oben durch einen Deckel verschlossen. Vorteil dieser Ausgestaltung ist, daß die Targetkonstruktion in einfacher Weise mittels eines Krans von oben in die Vakuumkammer einbringbar ist.

Die Gehäuse für den Zahnriemenantrieb und den Kühlmittelzu- und -ablauf sind an dem Deckel angebracht und daher ebenfalls einfach von oben zugänglich.

Nachfolgend werden vorteilhafte Ausgestaltungen der Erfindung anhand eines bevorzugten Ausführungsbeispiels und der Zeichnung näher erläutert. Es zeigt:

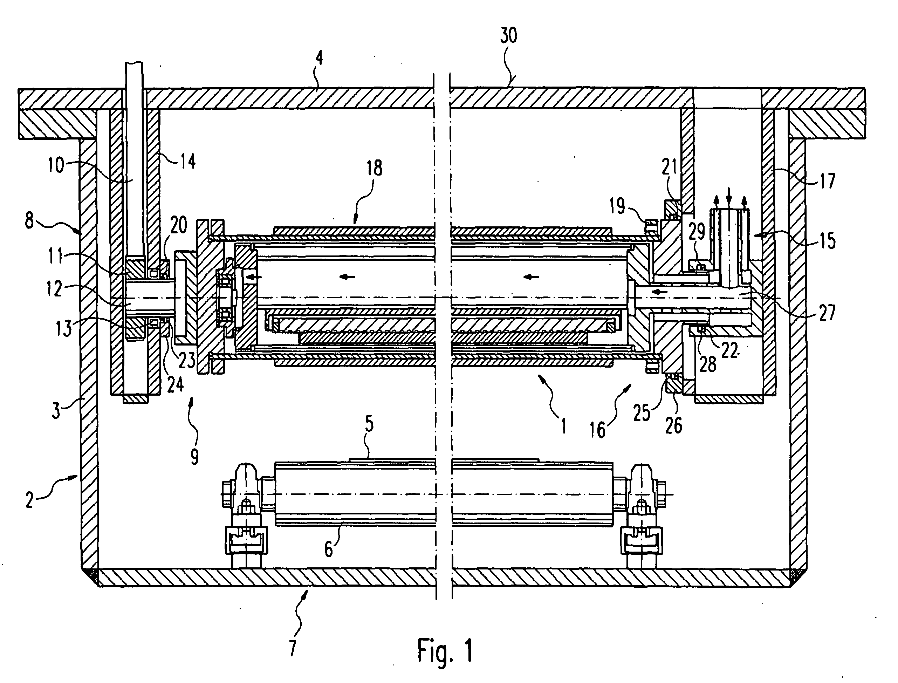

- Fig. 1: eine schematische, geschnittene Darstellung eines Ausführungsbeispiels eines erfindungsgemäß ausgestalteten Magnetrons.

Fig. 1 zeigt in einer schematischen Schnittansicht ein Ausführungsbeispiel eines erfindungsgemäß ausgestalteten Magnetrons 1 in einer Gesamtansicht. Das Magnetron 1 ist in einer Vakuumkammer 2 angeordnet, welche beispielsweise in Form eines Trogs 3 mit einem Deckel 4 ausgeführt sein kann.

Das erfindungsgemäße Magnetron 1 ist insbesondere zur Beschichtung von großflächigen Substraten, beispielsweise Flachglas, mittels eines Zerstäubungs- bzw. Sputterverfahrens geeignet. Hierbei wird eine ein- oder mehrschichtige Beschichtung, beispielsweise eine Wärmeschutzbeschichtung, auf das Substrat aufgebracht.

In Fig. 1 ist ein Substrat 5 unterhalb des Magnetrons 1 dargestellt, welches auf einer beispielsweise aus mehreren Rollen 6 bestehenden Fördereinrichtung 7 durch die Vakuumkammer 2 unter dem Magnetron 1 vorbeigeführt und dabei beschichtet wird.

Das Magnetron 1 ist in der Vakuumkammer 2 fest angeordnet. Eine Antriebskonstruktion 8, welche beispielsweise in Form eines Zahnriemenantriebs 8 ausgeführt sein kann, ist an einem ersten Ende 9 des Magnetrons 1 zum rotatorischen Antrieb der rotierenden Bauteile des Magnetrons 1 vorgesehen. Dabei greift ein Zahnriemen 10 in eine entsprechend ausgestaltete Zahnscheibe 11 ein, welche in kraftschlüssiger Verbindung mit einer Welle 12 steht. Die Welle 12 ist in einem Lager 13 gelagert, welches in einem Gehäuse 14 des Zahnriemenantriebs 8 angeordnet ist.

Ein Kühlmittelzu- und -ablauf 15 ist an einem zweiten Ende 16 des Magnetrons 1 vorgesehen. Der Kühlmittelzu- und - ablauf 15 ist dabei ebenfalls in einem Gehäuse 17 angeordnet.

Die rotierenden Bauteile des Magnetrons 1 sind am zweiten Ende 16 des Magnetrons 1 in einem Lager 19 gelagert, welches im Ausführungsbeispiel an dem Gehäuse 14 des Kühlmittelzu- und -ablaufs 15 ausgebildet ist.

Erfindungsgemäß ist ein Kühlmittelkreislauf 18 gegenüber der Vakuumkammer 2 und die Vakuumkammer 2 gegenüber der Umgebung mittels mehrerer Dichtungen 20, 21 und 22 abgedichtet.

Dabei ist die dritte Dichtung 20 am ersten Ende 9 des Magnetrons 1 zwischen dem Gehäuse 14 des Zahnriemenantriebs 8 und der Welle 12 angeordnet und dichtet die Vakuumkammer 2 gegen die Umgebung bzw. den dort herrschenden Atmosphärendruck ab. Die dritte Dichtung 20 liegt dabei in einer Nut 23 eines Flansches 24, der an dem Gehäuse 14 des Zahnriemenantriebs 8 angeordnet ist. Dadurch, daß der Atmosphärendruck höher als der Druck in der Vakuumkammer 2 ist, wird die Dichtung 20 in den Flansch gepreßt und dichtet zuverlässig ab.

Die erste Dichtung 21 ist am zweiten Ende 16 des Magnetrons 1 angeordnet. Sie ist ähnlich der dritten Dichtung 20 in einer Nut 25 eines weiteren Flansches 26 angeordnet. Der Flansch 26 ist an dem Gehäuse 17 des Kühlmittelzu- und -ablaufs 15 angeordnet. Auch hier dichtet die Dichtung 21 die Vakuumkammer 2 gegenüber der Atmosphäre ab. Die Dichtung 21 wird ebenfalls durch den Atmosphärendruck in die Nut 25 eingepreßt, wodurch eine zuverlässige Dichtwirkung erzielt wird.

Die zweite Dichtung 22 sorgt für die Abdichtung des Kühlmittelkreislaufs 18 gegenüber dem Atmosphärendruck. Sie ist an einem Zulauf 27 des Kühlmittelkreislaufs 18 angeordnet. Vorzugsweise ist hier ebenfalls eine Nut 28 in einem Flansch 29 ausgebildet, in welchem die Dichtung 22 liegt.

Durch die erwähnte zweistufige und im Ausführungsbeispiel dreiteilige Ausgestaltung der Abdichtung zwischen Vakuumkammer 2 bzw. Kühlkreislauf 18 und Atmosphärendruck in der Umgebung wird eine zuverlässigere Dichtwirkung erzielt, als wenn eine einzelne Dichtung sowohl für die Abdichtung des Kühlkreislaufs 18 als auch der Vakuumkammer 2 gegen die Umgebung zuständig ist. Einerseits wird durch die Trennung der Dichtungen 20, 21 und 22 erreicht, daß jeweils entweder Medien gleichen Aggregatzustands oder niedrigeren Druckunterschieds gegeneinander abgedichtet werden. So ist der Druckunterschied zwischen dem Kühlmedium und dem Atmosphärendruck geringer als der Druckunterschied zwischen dem Kühlmedium und dem Vakuum, wodurch die Dichtung 22 nicht so stark belastet wird. Die Abdichtung der Vakuumkammer 2 gegen den Atmosphärendruck durch die Dichtungen 20 und 21 wiederum betrifft eine Abdichtung zwischen einem Gas unter Atmosphärendruck und einem zumindest teilweise evakuierten Raum, so daß ausschließlich eine Gasdichtung stattfinden muß. Außerdem ist auch hier der Druckunterschied verringert.

Eine ähnliche Anordnung der Dichtungen 20,21 und 22 wäre theoretisch bei einem von der Seite in die Vakuumkammer 2 eingeführten und auch von dort angetriebenen Magnetron 1 ebenfalls denkbar. Die Einführung des Magnetrons 1 von der Seite in die Vakuumkammer 2 ist jedoch mit einem hohen technischen Aufwand verbunden. Bedingt durch die Anordnung des erfindungsgemäß ausgestalteten Magnetrons 1 in einer nach oben offenen Vakuumkammer 2, welche nach oben durch einen Deckel 4 abgeschlossen ist, sowie durch die Zuführung des Kühlmittels und des Antriebs über Gehäuse 14 und 17 ebenfalls von oben ist das erfindungsgemäß ausgestaltete Magnetron 1 in einfacher Weise beispielsweise mittels eines Krans von oben in die Vakuumkammer 2 einbringbar, was erheblich weniger technischen Aufwand bedeutet und daher kostengünstiger ist. Dabei ist zu bedenken, daß dieser Vorgang nicht nur bei der Erstmontage, sondern bei jedem Targetwechsel erforderlich ist.

## Patentansprüche

1. Magnetron (1), welches in einer Vakuumkammer (2) angeordnet ist, mit einer länglich hohlen Targetkonstruktion, die in der Vakuumkammer (2) drehbar gelagert ist, und einer innerhalb der Targetkonstruktion angeordneten Magnetkonstruktion, welche zumindest einen Magneten aufweist, und mit einem die Targetkonstruktion kühlenden Kühlmittelkreislauf (18),
wobei die Vakuumkammer (2) mittels zumindest einer ersten Dichtung (21) und der Kühlmittelkreislauf (18) mittels einer zweiten Dichtung (22) jeweils gegenüber dem Atmosphärendruck abgedichtet sind,
wobei eine dritte Dichtung (20), welche die Vakuumkammer gegenüber dem Atmosphärendruck abdichtet, an einem ersten Ende (9) des Magnetrons (1) angeordnet ist, und
wobei die Dichtungen (20,21,22) separat voneinander angeordnet sind.

2. Magnetron nach Anspruch 1,
**dadurch gekennzeichnet,**
**daß** die dritte Dichtung (20) in einer Nut (23) angeordnet ist, welche in einem Flansch (24) ausgebildet ist.

3. Magnetron nach Anspruch 2,
**dadurch gekennzeichnet,**
**daß** der Flansch (24) an einem Gehäuse (14) eines das Magnetron antreibenden Zahnriemenantriebs (8) angeordnet ist.

4. Magnetron nach Anspruch 3,
**dadurch gekennzeichnet,**
**daß** in dem Gehäuse (14) Atmosphärendruck anliegt.

5. Magnetron nach Anspruch 4,
**dadurch gekennzeichnet,**
**daß** die dritte Dichtung (20) durch den Atmosphärendruck in den Flansch (24) eingepreßt ist.

6. Magnetron nach einem der Ansprüche 1 bis 5,
**dadurch gekennzeichnet,**
**daß** die erste Dichtung (21) an einem zweiten Ende (16) des Magnetrons (1) angeordnet ist.

7. Magnetron nach Anspruch 6,
**dadurch gekennzeichnet,**
**daß** die erste Dichtung (21) in einer Nut (25) angeordnet ist, welche in einem Flansch (26) ausgebildet ist.

8. Magnetron nach Anspruch 7,
**dadurch gekennzeichnet,**
**daß** der Flansch (26) an einem Gehäuse (17) eines das Magnetron speisenden Kühlmittelzu- und -ablaufs (15) angeordnet ist.

9. Magnetron nach Anspruch 8,
**dadurch gekennzeichnet,**
**daß** in dem Gehäuse (17) Atmosphärendruck anliegt.

10. Magnetron nach Anspruch 9,
**dadurch gekennzeichnet,**
**daß** die erste Dichtung (21) durch den Atmosphärendruck in den Flansch (26) eingepreßt ist.

11. Magnetron nach einem der Ansprüche 1 bis 10,
**dadurch gekennzeichnet,**
**daß** die zweite Dichtung (22) an einem Zulauf (27) des Kühlmittelsystems (18) angeordnet ist.

12. Magnetron nach Anspruch 11,
**dadurch gekennzeichnet,**
**daß** die zweite Dichtung (22) in einer Nut (28) angeordnet ist, welche in einem Flansch (29) ausgebildet ist.

13. Magnetron nach Anspruch 12,
**dadurch gekennzeichnet,**
**daß** der Flansch (29) in einem Gehäuse (17) eines das Magnetron speisenden Kühlmittelzu- und -ablaufs (15) angeordnet ist.

14. Magnetron nach Anspruch 13,
**dadurch gekennzeichnet,**
**daß** in dem Gehäuse (17) Atmosphärendruck anliegt.

15. Magnetron nach einem der Ansprüche 8 bis 10, 13 oder 14,
**dadurch gekennzeichnet,**
**daß** die Vakuumkammer (2) trogförmig ausgebildet und an einer Oberseite (30) durch einen Deckel (4) abgeschlossen ist.

16. Magnetron nach Anspruch 15,
**dadurch gekennzeichnet,**
**daß** das Gehäuse (14; 17) oder die Gehäuse (14, 17) an dem Deckel (4) angeordnet ist bzw. sind und sich von diesem aus nach unten in die Vakuumkammer (2) hinein erstreckt bzw. erstrecken.

17. Magnetron nach Anspruch 15 oder 16,
**dadurch gekennzeichnet,**
**daß** die Targetkonstruktion (21) und/oder die Magnetkonstruktion (25) nach Abnahme des Deckels (4) von oben in die Vakuumkammer (2) einbringbar und entfernbar ist.

## Claims

1. Magnetron (1), which is arranged in a vacuum chamber (2), having a target construction which is longitudinally hollow and is rotatably mounted in the vacuum chamber, and a magnet construction arranged within the target construction, which magnet construction has at least one magnet, and having a coolant circuit (18) which cools the target construction,
wherein the vacuum chamber (2) is sealed with respect to atmospheric pressure using at least one first seal (21) and the coolant circuit (18) is sealed with respect to atmospheric pressure using a second seal (22),
wherein a third seal (20), which seals the vacuum chamber with respect to atmospheric pressure, is arranged at a first end (9) of the magnetron (1) and wherein the seals (20, 21, 22) are arranged separately from one another.

2. Magnetron according to Claim 1, **characterized in that** the third seal (20) is arranged in a groove (23), which is formed in a flange (24).

3. Magnetron according to Claim 2, **characterized in that** the flange (24) is arranged on a housing (14) of a gearwheel drive (8) driving the magnetron.

4. Magnetron according to Claim 3, **characterized in that** atmospheric pressure prevails in the housing (14).

5. Magnetron according to Claim 4, **characterized in that** the third seal (20) is pressed into the flange (24) by way of the atmospheric pressure.

6. Magnetron according to one of Claims 1 to 5, **characterized in that** the first seal (21) is arranged at a second end (16) of the magnetron (1).

7. Magnetron according to Claim 6, **characterized in that** the first seal (21) is arranged in a groove (25), which is formed in a flange (26).

8. Magnetron according to Claim 7, **characterized in that** the flange (26) is arranged on a housing (17) of a coolant inlet and outlet (15) through which coolant is supplied to the magnetron.

9. Magnetron according to Claim 8, **characterized in that** atmospheric pressure prevails in the housing (17).

10. Magnetron according to Claim 9, **characterized in that** the first seal (21) is pressed into the flange (26) by way of the atmospheric pressure.

11. Magnetron according to one of Claims 1 to 10, **characterized in that** the second seal (22) is arranged at an inlet (27) of the coolant system (18).

12. Magnetron according to Claim 11, **characterized in that** the second seal (22) is arranged in a groove (28), which is formed in a flange (29).

13. Magnetron according to Claim 12, **characterized in that** the flange (29) is arranged in a housing (17) of a coolant inlet and outlet (15) through which coolant is supplied to the magnetron.

14. Magnetron according to Claim 13, **characterized in that** atmospheric pressure prevails in the housing (17).

15. Magnetron according to one of Claims 8 to 10, 13 and 14, **characterized in that** the vacuum chamber (2) is configured in the shape of a trough and is closed off on an upper side (30) by a cover (4).

16. Magnetron according to Claim 15, **characterized in that** the housing (14; 17) or the housings (14, 17) is/are arranged on the cover (4) and extend/extends from said cover (4) downwards into the vacuum chamber (2).

17. Magnetron according to Claim 15 or 16, **characterized in that** the target construction (21) and/or the magnet construction (25) can be introduced into and removed from the vacuum chamber (2) from above once the cover (4) has been taken off.

## Revendications

1. Magnétron (1), qui est agencé dans une chambre à vide (2), comprenant une unité de cible allongée et creuse, qui est montée rotative dans la chambre à vide (2), et une unité d'aimant qui est agencée à l'intérieur de l'unité de cible et présente au moins un aimant, et comprenant également un circuit de fluide de refroidissement (18) qui refroidit l'unité de cible, magnétron
dans lequel l'étanchéité par rapport à la pression atmosphérique de la chambre à vide (2) est assurée au moyen d'au moins un premier joint d'étanchéité (21), et celle du circuit de fluide de refroidissement (18), également par rapport à la pression atmosphérique, au moyen d'un deuxième joint d'étanchéité (22),
dans lequel un troisième joint d'étanchéité (20), qui assure l'étanchéité de la chambre à vide par rapport à la pression atmosphérique, est agencé à une première extrémité (9) du magnétron (1), et
dans lequel les joints d'étanchéité (20, 21, 22) sont agencés séparément les uns des autres.

2. Magnétron selon la revendication 1,
**caractérisé en ce que** le troisième joint d'étanchéité (20) est agencé dans une rainure (23), qui est formée dans un flasque (24).

3. Magnétron selon la revendication 2,
**caractérisé en ce que** le flasque (24) est agencé sur un carter (14) d'une transmission à courroie crantée (8) entraînant le magnétron.

4. Magnétron selon la revendication 3,
**caractérisé en ce que** dans le carter (14) règne la pression atmosphérique.

5. Magnétron selon la revendication 4,
**caractérisé en ce que** le troisième joint d'étanchéité (20) est pressé dans le flasque (24) par la pression atmosphérique.

6. Magnétron selon l'une des revendications 1 à 5,
**caractérisé en ce que** le premier joint d'étanchéité (21) est agencé à une deuxième extrémité (16) du magnétron (1).

7. Magnétron selon la revendication 6,
**caractérisé en ce que** le premier joint d'étanchéité (21) est agencé dans une rainure (25), qui est formée dans un flasque (26).

8. Magnétron selon la revendication 7,
**caractérisé en ce que** le flasque (26) est agencé sur un carter (17) d'un système d'arrivée et d'évacuation de fluide de refroidissement (15) alimentant le magnétron.

9. Magnétron selon la revendication 8,
**caractérisé en ce que** dans le carter (17) règne la pression atmosphérique.

10. Magnétron selon la revendication 9,
**caractérisé en ce que** le premier joint d'étanchéité (21) est pressé dans le flasque (26) par la pression atmosphérique.

11. Magnétron selon l'une des revendications 1 à 10,
**caractérisé en ce que** le deuxième joint d'étanchéité (22) est agencé au niveau d'un système d'arrivée (27) du système de fluide de refroidissement (18).

12. Magnétron selon la revendication 11,
**caractérisé en ce que** le deuxième joint d'étanchéité (22) est agencé dans une rainure (28), qui est formée dans un flasque (29).

13. Magnétron selon la revendication 12,
**caractérisé en ce que** le flasque (29) est agencé dans un carter (17) d'un système d'arrivée et d'évacuation de fluide de refroidissement (15) alimentant le magnétron.

14. Magnétron selon la revendication 13,
**caractérisé en ce que** dans le carter (17) règne la pression atmosphérique.

15. Magnétron selon l'une des revendications 8 à 10, 13 ou 14,
**caractérisé en ce que** la chambre à vide (2) est réalisée en forme de bac et est fermée par un couvercle (4) sur un côté supérieur (30).

16. Magnétron selon la revendication 15,
**caractérisé en ce que** le carter (14 ; 17) ou les carters (14, 17) est agencé, respectivement sont agencés sur le couvercle (4), et s'étend, respectivement s'étendent vers le bas à l'intérieur de la chambre à vide (2).

17. Magnétron selon la revendication 15 ou la revendication 16,
**caractérisé en ce que** l'unité de cible (21) et/ou l'unité d'aimant (25) peuvent, après retrait du couvercle (4), être insérées dans la chambre à vide (2) par le haut, et en être retirées également par le haut.
